(19)

**Europäisches Patentamt**
**European Patent Office**
**Office européen des brevets**

(11) **EP 4 564 248 B1**

(12) **EUROPEAN PATENT SPECIFICATION**

(45) Date of publication and mention
of the grant of the patent:
**14.01.2026 Bulletin 2026/03**

(21) Application number: **24207503.4**

(22) Date of filing: **18.10.2024**

(51) International Patent Classification (IPC):
*G06Q 10/04* (2023.01)    *G06N 20/00* (2019.01)
*G06Q 30/018* (2023.01)    *G06Q 50/02* (2024.01)
*G06N 3/044* (2023.01)    *G06N 3/08* (2023.01)

(52) Cooperative Patent Classification (CPC):
**G06Q 10/04; G06N 3/044; G06N 3/08; G06N 20/00;**
**G06Q 30/018; G06Q 50/02**

(54) **ESTIMATION OF DYNAMIC ADOPTION INDEX AND TRANSITION TIME FOR SHIFTING TO REGENERATIVE AGRICULTURE**

SCHÄTZUNG DES DYNAMISCHEN ADOPTIONSINDEX UND ÜBERGANGSZEIT ZUR VERSCHIEBUNG IN DIE REGENERATIVE LANDWIRTSCHAFT

ESTIMATION D'INDICE D'ADOPTION DYNAMIQUE ET DE TEMPS DE TRANSITION POUR PASSER À UNE AGRICULTURE RÉGÉNÉRATIVE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **28.11.2023 IN 202321080693**

(43) Date of publication of application:
**04.06.2025 Bulletin 2025/23**

(73) Proprietor: **Tata Consultancy Services Limited Maharashtra (IN)**

(72) Inventors:
• **MOHITE, Jayantrao**
  **400601 Thane (IN)**

• **SAWANT, Suryakant Ashok**
  **411013 Pune (IN)**
• **PANDIT, Ankur**
  **452006 Indore (IN)**
• **SIVALINGAM, Ravinkumar**
  **600096 Chennai (IN)**
• **PAPPULA, Srinivasu**
  **500034 Hyderabad (IN)**

(74) Representative: **Goddar, Heinz J.**
**Boehmert & Boehmert**
**Anwaltspartnerschaft mbB**
**Pettenkoferstrasse 22**
**80336 München (DE)**

(56) References cited:
**US-A1- 2023 107 533**

**Description**

CROSS-REFERENCE TO RELATED APPLICATIONS AND PRIORITY

The present application claims priority to Indian application no. 202321080693, filed on 28 November 2023.

TECHNICAL FIELD

The disclosure herein generally relates to the field of agriculture, and, more particularly, to system and method for estimation of dynamic adoption index and transition time for shifting to regenerative agriculture.

BACKGROUND

Climate change is one of the major concerns in today's world as it is causing a tremendous shift in unseasonal rainfall, extreme temperature, unpredictable floods, droughts, and/or the like. Various measures are being undertaken to minimize the impact of climate change. One such measure is reducing carbon footprint. Land use, land cover change and agricultural practices contribute about 20% of global annual emission of carbon dioxide ($CO_2$). Agriculture is one of the major contributors to total green-house gases (GHG) emissions. Processes related to the agricultural practices from industry to farm to house, emit GHG's at every step that significantly contributes to global warming.

There are various models being used or developed for estimation of sequestration or emissions happening over agriculture fields based on the historical and current information provided by users. Those models are developed for seeing future emissions also based on user inputs on the agricultural practices. All these models provide information on the GHG emissions and associated impact of various agricultural activities. Additionally, there are remote sensing based methods focused on estimation of individual factors associated with GHG emissions such as Soil Organic Carbon (SOC), Tillage, Cover Crop and/or the like. Various empirical and/or Machine Learning based models are developed to estimate each of these components.

There are various practices being suggested based on various years of research and associated findings for reduction or control of GHG emissions. Those practices include reduced or no use of tillage, optimal use of irrigation and fertilizers, cultivation of cover crop, no stubble burning, and/or the like. However, in spite of rich data, information, knowledge, models available for various components associated with GHG emissions, conventional methods are mainly focused on personalized recommendations specific to a farm only to reduce or minimize the GHG emissions, and dependent on user inputs on agriculture practices for generating various emission and/or sequestration scenarios. US2023/107533A1 discloses a computer-implemented method for estimating greenhouse gas (GHG) emissions, wherein various data are input to the system which uses a process-based model to provide time series GHG estimates via a learning model, but fails to disclose the use of a knowledge graph as claimed.

SUMMARY

Embodiments of the present disclosure present technological improvements as solutions to one or more of the above-mentioned technical problems recognized by the inventors in conventional systems. For example, in one embodiment, a processor implemented method is provided. The processor implemented method, comprising receiving, via one or more processors, a plurality of data pertaining to an agriculture land for a specific season from a plurality of seasons, wherein the plurality of data comprises a plurality of aerial and non-aerial data, and a plurality of followed agriculture practices; estimating, via the one or more processors, a plurality of greenhouse gases (GHG) emissions associated with each of a plurality of agricultural activity within each of the plurality of seasons using a machine learning model trained with the plurality of data; creating, via the one or more processors, a knowledge graph capturing a causal relationship between the plurality of data and the plurality of GHG emissions; transforming, via the one or more processors, the knowledge graph into a plurality of feature embeddings using a graph embedding technique, wherein the plurality of feature embeddings capture (i) a domain-specific context, (ii) a semantic context and (iii) inter-relationships between the plurality of data and the plurality of GHG emissions; training, via the one or more processors, a graph based machine learning model with graph-based regularization and attention mechanisms using the plurality of feature embeddings and the plurality of GHG emissions; predicting, via the one or more processors, a future value of the plurality of GHG emissions using the graph based machine learning model for a subsequent season of the specific season from the plurality of seasons; recommending, via the one or more processors, a plurality of sustainable agriculture practices to one or more users based on the future value of the plurality of GHG emissions and the plurality of feature embeddings of the knowledge graph; computing, via the one or more processors, a dynamic adoption index using the future value of the plurality of GHG emissions, a plurality of temporal weights derived from the knowledge graph, the recommended plurality of sustainable agriculture practices, and the plurality of followed agriculture practices; and estimating, via the one or more processors, a time required by each user from the one or more users using a machine learning model for transitioning to regenerative agriculture practices based on the dynamic adoption index, and one or more factors.

In another aspect, a system is provided. The system comprising a memory storing instructions; one or more communication interfaces; and one or more hardware processors coupled to the memory via the one or more communication interfaces, wherein the one or more hardware processors are configured by the instructions to: receive a plurality of data pertaining to an agriculture land for a specific season from a plurality of seasons, wherein the plurality of data comprises a plurality of aerial and non-aerial data, and a plurality of followed agriculture practices; estimate a plurality of greenhouse gases (GHG) emissions associated with each of a plurality of agricultural activity within each of the plurality of seasons using a machine learning model trained with the plurality of data; create a knowledge graph capturing a causal relationship between the plurality of data and the plurality of GHG emissions; transform the knowledge graph into a plurality of feature embeddings using a graph embedding technique, wherein the plurality of feature embeddings capture (i) a domain-specific context, (ii) a semantic context and (iii) inter-relationships between the plurality of data and the plurality of GHG emissions; train a graph based machine learning model with graph-based regularization and attention mechanisms using the plurality of feature embeddings and the plurality of GHG emissions; predict a future value of the plurality of GHG emissions using the graph based machine learning model for a subsequent season of the specific season from the plurality of seasons; recommend a plurality of sustainable agriculture practices to one or more users based on the future value of the plurality of GHG emissions and the plurality of feature embeddings of the knowledge graph; compute a dynamic adoption index using the future value of the plurality of GHG emissions, a plurality of temporal weights derived from the knowledge graph, the recommended plurality of sustainable agriculture practices, and the plurality of followed agriculture practices; and estimate a time required by each user from the one or more users using a machine learning model for transitioning to regenerative agriculture practices based on the dynamic adoption index, and one or more factors.

In yet another aspect, a non-transitory computer readable medium is provided. The non-transitory computer readable medium are configured by instructions for receiving, a plurality of data pertaining to an agriculture land for a specific season from a plurality of seasons, wherein the plurality of data comprises a plurality of aerial and non-aerial data, and a plurality of followed agriculture practices; estimating, a plurality of greenhouse gases (GHG) emissions associated with each of a plurality of agricultural activity within each of the plurality of seasons using a machine learning model trained with the plurality of data; creating, a knowledge graph capturing a causal relationship between the plurality of data and the plurality of GHG emissions; transforming, the knowledge graph into a plurality of feature embeddings using a graph embedding technique, wherein the plurality of feature embeddings capture (i) a domain-specific context, (ii) a semantic context and (iii) inter-relationships between the plurality of data and the plurality of GHG emissions; training, a graph based machine learning model with graph-based regularization and attention mechanisms using the plurality of feature embeddings and the plurality of GHG emissions; predicting, a future value of the plurality of GHG emissions using the graph based machine learning model for a subsequent season of the specific season from the plurality of seasons; recommending, a plurality of sustainable agriculture practices to one or more users based on the future value of the plurality of GHG emissions and the plurality of feature embeddings of the knowledge graph; computing, a dynamic adoption index using the future value of the plurality of GHG emissions, a plurality of temporal weights derived from the knowledge graph, the recommended plurality of sustainable agriculture practices, and the plurality of followed agriculture practices; and estimating, a time required by each user from the one or more users using a machine learning model for transitioning to regenerative agriculture practices based on the dynamic adoption index, and one or more factors.

In accordance with an embodiment of the present disclosure, recommending the plurality of sustainable agriculture practices enables minimizing the plurality of GHG emissions to an optimal level.

In accordance with an embodiment of the present disclosure, the one or more factors include user expertise, availability of resources, financial constraints, and regional conditions.

In accordance with an embodiment of the present disclosure, the time required by each user from the one or more users for transitioning to regenerative agriculture practices is dynamically updated with each season from the plurality of seasons.

It is to be understood that both the foregoing general description and the following detailed description are exemplary and explanatory only and are not restrictive of the invention, as claimed.

BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG. 1 illustrates an exemplary system for estimation of dynamic adoption index and transition time for shifting to regenerative agriculture, according to some embodiments of the present disclosure.
FIGS. 2A and 2B illustrate an exemplary flow diagram illustrating a method for estimation of dynamic adoption index and transition time for shifting to regenerative agriculture, in accordance with some embodiments of the present disclosure.

## DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments. It is intended that the following detailed description be considered as exemplary only, with the true scope being indicated by the following embodiments described herein.

In Today's scenario, climatic change is a matter of concern due to increase in GHG emissions leading to global warming. Agriculture is major contributor in GHG emissions. Processes related to agricultural practices from industry to farm to house, emit GHG's at every step that significantly contributes to global warming.

There are conventional models that provide future emission or sequestration scenarios depending on the user input of agricultural practices, however conventional models fail to provide data related to historical trends of crops grown, practices followed and associated sequestration/emissions and making use of the same to forecast the sequestration/emissions for a specific farm.

While many models are providing recommended set of agricultural practices or set of operations to be followed based on variety of field, crop, soil information, all of them are limited to suggesting something for the farm, but nobody is looking for the operations which were followed on the farm. Due to various unforeseen situations occurring on the farm in real time, it is not always possible for a farmer to follow all suggested operations. Hence there is a need to analyze a trade-off between what was suggested with what was followed. There is need to analyze the adoption trend by the farmers. Due to trade-off between what was suggested with what was followed on the farm, there is always going to be variable time or season window (specific to the farm) which is needed by the farm to move to regenerative agriculture from traditional set of practices. This is always a function of what is being followed and what was recommended.

The present disclosure addresses the unresolved problem of the conventional methods by providing a system and method for estimation of dynamic adoption index and transition time for shifting to regenerative agriculture. In the context of present disclosure, the expressions 'land' and 'farm' can be interchangeably used throughout the description. The method of the present disclosure utilizes knowledge graph-driven machine learning for GHG emissions forecasting from a farm using historical information associated with farm derived from remote sensing and on-field sensors. Further, a dynamic Adoption Index Estimation is provided with Knowledge-Driven Machine Learning and Data Integration using the data on forecasted emissions, recommended practices (what is suggested) and followed practices on the farm (what was followed). Here, the recommended practices are suggested by making use of personalized field information, GHG emissions predicted for the farm and one or more models. Moreover, practices followed on the farm are derived using temporal remote sensing and on-field sensor information for the farm from a current season. Further, Dynamic Transition Time is estimated with Machine Learning and Context-Sensitive Modeling. Trend of what was recommended with what was followed is used to derive the time/seasons needed. More specifically, the present disclosure describes the following:

1. Use of knowledge graphs to incorporate causal relationships between agricultural practices, crops, and emissions into the forecasting models for prediction of GHG emissions.
2. Estimation of dynamic adoption index that adapts over time and considers multiple factors, such as forecasted emissions, recommended practices and suggested practices.
3. Approach of quantitatively estimating time needed for farmers to transition to regenerative practices based on data-driven modeling and user inputs.

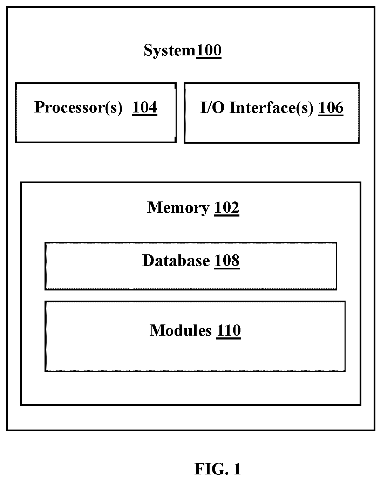

Referring now to the drawings, and more particularly to FIGS. 1 through 2B, where similar reference characters denote corresponding features consistently throughout the figures, there are shown preferred embodiments and these embodiments are described in the context of the following exemplary system and/or method.

FIG. 1 illustrates an exemplary system for estimation of dynamic adoption index and transition time for shifting to regenerative agriculture, according to some embodiments of the present disclosure.

In an embodiment, the system 100 includes or is otherwise in communication with one or more hardware processors 104, communication interface device(s) or input/output (I/O) interface(s) 106, and one or more data storage devices or memory 102 operatively coupled to the one or more hardware processors 104. The one or more hardware processors 104, the memory 102, and the I/O interface(s) 106 may be coupled to a system bus 108 or a similar mechanism.

The system 100, with one or more hardware processors present across the physically distributed components, is configured to execute functions of one or more functional blocks or components (servers) of the system 100. In an embodiment, the servers may be used to process requests and send responses, to execute an algorithm for detection, model training, and/or the like.

Referring to the components of system 100, in an embodiment, the I/O interface(s) 106 may include a variety of software and hardware interfaces, for example, a web interface, a graphical user interface, interfaces for peripheral device(s), such as a keyboard, a mouse, an external memory, a plurality of sensor devices, a printer and the like. Further, the I/O interface(s) 106 may enable the system 100 to communicate with other devices, such as web servers and external databases.

The I/O interface(s) 106 can facilitate multiple communications within a wide variety of networks and protocol types, including wired networks, for example, local area network (LAN), cable, etc., and wireless networks, such as Wireless LAN (WLAN), cellular, or satellite. For the purpose, the I/O interface(s) 106 may include one or more ports for connecting a number of computing systems with one another or to another server computer. Further, the I/O interface (s) 106 can include one or more ports for connecting to a number of external devices or to another server or devices. The external devices can include Global Positioning System (GPS) enabled hand-held devices with sensing, processing, communicating, displaying and storage capability, A mobile phone or similar portable handheld device for running a mobile crowdsourcing application or program, external third party data sources for various types of information associated with the agriculture land, practices, weather, on-field sensors.

The one or more hardware processors 104 may be implemented as one or more microprocessors, microcomputers, microcontrollers, digital signal processors, central processing units, state machines, logic circuitries, and/or any devices that manipulate signals based on operational instructions. Among other capabilities, the one or more hardware processors 104 are configured to fetch and execute computer-readable instructions stored in the memory 102. In the context of the present disclosure, the expressions 'processors' and 'hardware processors' may be used interchangeably. In an embodiment, the system 100 can be implemented in a variety of computing systems, such as laptop computers, portable computer, notebooks, hand-held devices, workstations, mainframe computers, servers, a network cloud and the like.

The memory 102 may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes.

In an embodiment, the memory 102 includes a plurality of modules 110 distributed across each of the distributed components (servers). The plurality of modules 110 include programs or coded instructions that supplement applications or functions performed by the components of system 100 for executing different steps involved in the process of estimating dynamic adoption index and transition time for shifting to regenerative agriculture, being performed by the system 100. The plurality of modules 110, amongst other things, can include routines, programs, objects, components, and data structures, which performs particular tasks or implement particular abstract data types. The plurality of modules 110 may also be used as, signal processor(s), node machine(s), logic circuitries, and/or any other device or component that manipulates signals based on operational instructions. Further, the plurality of modules 110 can be used by hardware, by computer-readable instructions executed by the one or more hardware processors 104, or by a combination thereof. The plurality of modules 110 can include various sub-modules (not shown).

Further, the memory 102 may comprise information pertaining to input(s)/output(s) of each step performed by the processor(s) 104 of the system100 and methods of the present disclosure. Further, the memory 102 includes a database 108, which can be a distributed storage for each of the components such as servers depicted in FIG. 3. The database (or repository) 108 may include a plurality of abstracted pieces of code for refinement and data that is processed, received, or generated as a result of the execution of the plurality of modules in the module(s) 110. The database stores a plurality of aerial and non-aerial data which includes satellite data, weather data, on-field sensors data, soilGrids data on various soil attributes, temporal knowledge and inferences associated with an agriculture land, various geospatial datasets available on crop map types, soil types, and weather, one or more models such as machine learning models and data-based models to forecast GHG emissions, estimate adoption index, and estimate transition time for moving from traditional to regenerative agriculture, and corresponding inputs and outputs of the one or more models.

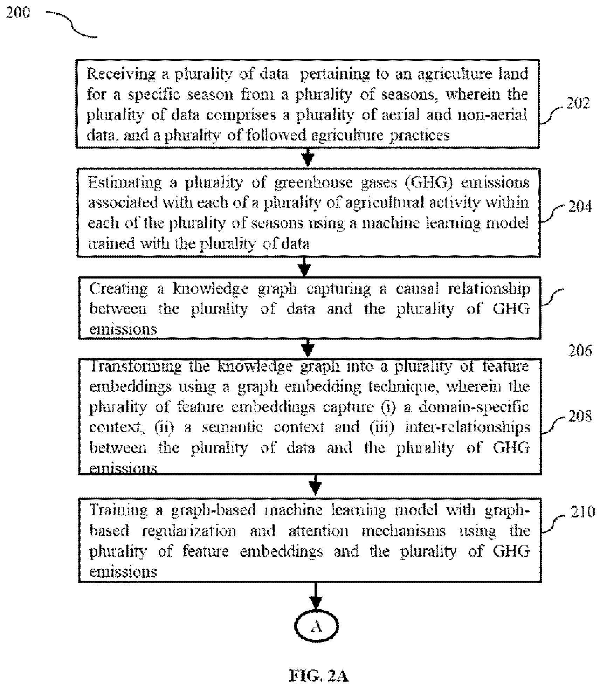

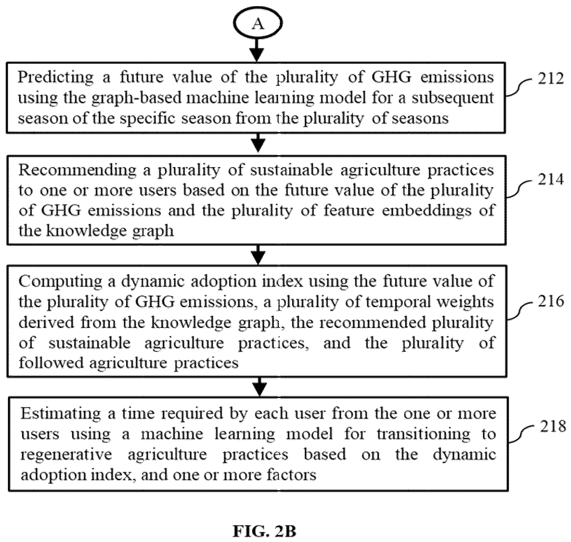

Although the database 108 is shown internal to the system 100, it will be noted that, in alternate embodiments, the database 108 can also be implemented external to the system 100, and communicatively coupled to the system 100. The data contained within such an external database may be periodically updated. For example, new data may be added into the database (not shown in FIG. 1) and/or existing data may be modified and/or non-useful data may be deleted from the database. In one example, the data may be stored in an external system, such as a Lightweight Directory Access Protocol (LDAP) directory and a Relational Database Management System (RDBMS) or any non-relational database such as NoSQL or document databases. Functions of the components of the system 100 are now explained with reference to the steps in flow diagram in FIGS. 2A and2B.

FIGS. 2A and 2B, with reference to FIG. 1, illustrate an exemplary flow diagram illustrating a method 200 for estimation of dynamic adoption index and transition time for shifting to regenerative agriculture, using the system 100 of FIG. 1, in accordance with some embodiments of the present disclosure. Referring to FIG. 1, in an embodiment, the system(s) 100 comprises one or more data storage devices or the memory 102 operatively coupled to the one or more hardware processors 104 and is configured to store instructions for execution of steps of the method by the one or more processors 104. The steps of the method 200 of the present disclosure will now be explained with reference to components of the system 100 of FIG. 1, the flow diagram as depicted in FIG. 2, and one or more examples. Although steps of the method 200 including process steps, method steps, techniques or the like may be described in a sequential order, such processes, methods, and techniques may be configured to work in alternate orders. In other words, any sequence or order of steps that may be described does not necessarily indicate a requirement that the steps be performed in that order. The steps of processes described herein may be performed in any practical order. Further, some steps may be performed simultaneously, or some steps may be performed alone or independently.

Referring to FIG. 2A, at step 202 of the present disclosure, the one or more hardware processors are configured to receive a plurality of data pertaining to an agriculture land for a specific season from a plurality of seasons, wherein the plurality of data comprises a plurality of aerial and non-aerial data, and a plurality of followed agriculture practices. The plurality of aerial data may comprise but are not limited to remote sensing data, weather data of the agricultural land, and data captured by drones or other aerial vehicles such as unmanned aerial vehicles (UAVs). The plurality of non-aerial data may comprise but are not limited to data obtained from on-field sensors, a plurality of crop data such as type of suitable crops sown in the agriculture field for past multiple seasons alternatively referred as historical crop data), a plurality of soil data such as soil texture, soil type, soil properties. The data on the suitable crops grown is taken from data sources such as United States-Cropland Data Layer (US-CDL), and derived using historical satellite images for each season using optical satellites such as Sentinel-2, Landsat 4,5,7,8 and Synthetic Aperture Radar sensors such as C-band Sentinel-1, L,X band SAR datasets. The plurality of followed agriculture practices on the agricultural land for the specific season and historical seasons in terms of tillage, use of irrigation, fertilizers, pesticides, herbicides are captured using mobile crowdsourcing or estimated using combination of satellite and on-field sensor information or human sensors or by manually visiting the fields. The plurality of followed practices are actual practices followed by the farmer during a crop season.

In an embodiment, at step 204 of the present disclosure, the one or more hardware processors are configured to estimate a plurality of greenhouse gases (GHG) emissions associated with each of a plurality of agricultural activity within each of the plurality of seasons using a machine learning model trained with the plurality of data. The machine learning model may include but not limited to artificial neural networks, deep learning networks, and/or the like. In an embodiment, the plurality of agricultural activities may include a sequence of operations performed on the agricultural land such as tillage, type and date of tillage, crop planting, irrigation application including date and time, pesticide application including name, date and quantity, fertilizer application including name, date and quantity, manure application, crop harvesting date, cover cropping including date of sowing and harvesting, and/or the like.

Further, at step 206 of the present disclosure, the one or more hardware processors are configured to create a knowledge graph capturing a causal relationship between the plurality of data and the plurality of GHG emissions. In other words, the knowledge graph is created that captures the causal relationships between a plurality of crops, agricultural practices, and the plurality of GHG emissions. The causal relationships are encoded as edges connecting corresponding nodes in the knowledge graph. The knowledge graph enriches the machine learning model used for forecasting the plurality of GHG emissions with domain knowledge, enabling more accurate and interpretable forecasts. By considering causal relationships, the machine learning model can provide insights into how specific practices impact emissions.

At step 208 of the present disclosure, the one or more hardware processors are configured to transform the knowledge graph into a plurality of feature embeddings using a graph embedding technique. The plurality of feature embeddings capture (i) a domain-specific context, (ii) a semantic context and (iii) relationships between the plurality of data and the plurality of GHG emissions. The graph embedding technique may include node2vec or graph attention networks to transform the knowledge graph into continuous vector representations. These feature embeddings capture the semantic context and relationships between crops, the plurality of followed agricultural practices, and the plurality of GHG emissions. Knowledge-driven feature embeddings capture domain-specific context and semantics, enriching the input data for GHG emission prediction model and enhancing its ability to generalize to unseen scenarios. By incorporating these feature embeddings derived from knowledge graph, the present disclosure utilizes domain knowledge encoded in the graph in addition to what normal ML model does for simple pattern-based forecasting.

At step 210 of the present disclosure, the one or more hardware processors are configured to train a graph based machine learning model with graph-based regularization and attention mechanisms using the plurality of feature embeddings and the plurality of GHG emissions. The graph based machine learning model may include but are not limited to as Graph Neural Networks (GNNs), tailored for forecasting GHG emissions. The graph based machine learning model takes historical GHG emissions data as input and learns from the feature embeddings of the knowledge graph to understand the causal dependencies between crops, followed agricultural practices, and the plurality of GHG emissions. Knowledge-driven feature engineering enhances the graph based machine learning model's ability to capture the nuances and interactions among different variables, leading to more robust GHG emission forecasts. Here, the graph based machine learning model incorporates temporal pattern recognition mechanisms to capture seasonality and trends in historical GHG emissions data. This enables the graph based machine learning model to identify cyclic patterns and seasonal variations in the plurality of GHG emissions for more accurate forecasting.

In an embodiment, graph-based machine learning model development is carried out by splitting the historical GHG emissions data into training and validation sets. Further, the graph-based machine learning model is trained using a training set and validated using a validation set. Optimized performance is achieved by fine-tuning the graph-based machine learning model's regularization and attention components.

The graph-based regularization and attention mechanisms are basically carried out to provide additional weightage or provide special emphasis on specific edges from the knowledge graph. Graph neural network (GNN) Model considers graph-based regularization with attention mechanisms. This graph-based regularization guides the learning process by emphasizing the importance of specific edges ( i.e., relationships) in the knowledge graph. Attention mechanisms allow the graph-based machine learning model to focus more on relevant relationships, improving the quality of GHG emission predictions.

Referring to FIG. 2B, at step 212 of the present disclosure, the one or more hardware processors are configured to predict a future value of the plurality of GHG emissions using the graph based machine learning model for a subsequent season of the specific season from the plurality of seasons. The trained graph-based machine learning model with graph-based regularization and attention mechanisms is used to forecast the GHG emissions for the next year/season for the agricultural land. The trained graph-based machine learning model considers the historical GHG emissions data, knowledge graph driven feature embeddings, and attention weights to make predictions as shown in the expression (1) below:

$$Forecasted\ GHG\ Emissions$$

$$= f\ (crops, practices\ followed, emissions, semantic\ context$$

$$and\ relationships\ between\ crops, practices, and\ emissions)\quad(1)$$

The Forecasted GHG emissions are the prediction of possible future value of the plurality of GHG emissions for the next season considering the crops, the plurality of followed agricultural practices and associated GHG emissions for the past $x$ seasons, $x$ varies from 2 *to n.* The semantic context and relationships between crops, the plurality of followed agricultural practices, and the plurality of GHG emissions are derived from the knowledge graph.

At step 214 of the present disclosure, the one or more hardware processors are configured to recommend a plurality of sustainable agriculture practices to one or more users based on the future value of the plurality of GHG emissions and the plurality of feature embeddings of the knowledge graph. The knowledge graph and the graph-based machine learning (i.e., GNN) model suggests agricultural practices for each agricultural land that reduces the plurality of GHG emissions. Further, based on the future value of the plurality of GHG emissions (i.e., forecasted GHG emissions) and knowledge graph relationships, the system 100 recommends specific sustainable agriculture practices to farmers. In an embodiment, the plurality of sustainable agriculture practices ensures to minimize the plurality of GHG emissions to an optimal level. This means that the plurality of sustainable agriculture practices that are recommended by the system 100 help in reducing the plurality of GHG emissions.

Further, at step 216 of the present disclosure, the one or more hardware processors are configured to estimate a dynamic adoption index using the future value of the plurality of GHG emissions, a plurality of temporal weights derived from the knowledge graph, the recommended plurality of sustainable agriculture practices, and the plurality of followed agriculture practices. As the season progresses, farmer carries out certain operations on the farm which may or may not be similar to what has been suggested by the recommendation engine. The recommendation engine is an analytical framework which uses variety of current and historical data sources about the agricultural land to generate some recommendations. To estimate or detect what agricultural practices have been followed by the farmer, a monitoring engine makes use of temporal data available from various sensors such as satellite, on-field sensors and feedback from the farmer and detect/estimate actual operations followed on the farm. The monitoring engine is an analytical framework which uses variety of datasets from satellites, sensors or other auxiliary sources along with artificial intelligence and machine learning (AI-ML) based algorithms to monitor various agricultural practices performed on the farm in non-invasive way. The monitoring engine provides the sequence of operation followed on the farm. In an embodiment, the plurality of temporal weights are assigned to the agricultural practices which has more impact on the plurality of GHG emissions. Higher weightage is given to the agricultural practices which has significant impact on the plurality of GHG emissions. So the plurality of temporal weights change throughout the season according to the plurality of sustainable agricultural practices (i.e., suggested practices). Here, the plurality of temporal weights change according to crop, stages, agricultural practices and their impact on the GHG emission. The knowledge graph is useful to assign the plurality of temporal weights as the knowledge graph can bring out those casual relationships between crops, the plurality of followed practices, the plurality of GHG emissions and impact of those agricultural practices on the plurality of GHG emissions.

In an embodiment, the dynamic adoption index is computed for a farm based on the plurality of temporal weights derived from the knowledge graph, the plurality of sustainable agricultural practices (i.e., suggested practices) and the plurality of followed agricultural practices as shown in expression (2) below:

$$Dynamic\ Adoption\ Index$$
$$= f(weights, suggested\ practices, followed\ practices)\ (2)$$

Here, the dynamic adoption index is computed at each time step during the crop season. Moreover, with each passing season, the data from current season is taken into consideration for dynamic updation of the knowledge graph which eventually helps in GHG emissions forecasting for the next season and updation/adjustment of the plurality of temporal weights.

At step 218 of the present disclosure, the one or more hardware processors are configured to estimate a time required by each user from the one or more users using a machine learning model for transitioning to regenerative agriculture practices based on the dynamic adoption index, and one or more factors. The one or more factors include user expertise, availability of resources, financial constraints, and regional conditions. The user expertise may include inputs received from users such as a farmer based on their expertise and knowledge. The financial constraints may include financial resources, government incentives, and/or the like. The regional conditions may include climate conditions of region, and regional regulations. In an embodiment, the time required by each user from the one or more users for transitioning to regenerative agriculture practices is dynamically updated with each season from the plurality of seasons. The time required by each user from the one or more users for transitioning to regenerative agriculture practices is referred as transition time.

In other words, the machine learning model is used to estimate the time needed for each farmer to transition to regenerative practices based on their dynamic adoption index, farmer inputs, available resources, and regional conditions. The dynamic adoption index is temporal in nature and used to estimate a temporal adoption rate. The transition time is dynamically updated with each passing season as the actual data on the dynamic adoption index is fed back to the machine learning model and the transition time is updated.

In an embodiment, the entire method of the present disclosure is further better understood by way of the following working example provided in Table 1.

Table 1

| Farm | Year | Crop | Agricultural practices | GHG emissions | Forecasted GHG emissions | Dynamic adoption index | Estimated Transition time |
|---|---|---|---|---|---|---|---|
| A | 1 | Wheat | Crop Rotation | 50 | - | - | - |
| A | 2 | Wheat | Crop Rotation | 52 | - | - | - |
| A | 3 | Corn | Crop Rotation, No-Till Farming | 55 | - | - | - |
| A | 4 | Soybean | Crop Rotation, No-Till Farming | 53 | - | - | - |
| A | 5 | Wheat | Crop Rotation, No-Till Farming | 48 | - | - | - |
| A | 6 | Corn | Crop Rotation, No-Till Farming | 47 | - | - | - |
| A | 7 | Soybean | **Forecasted** : No-Till Farming | - | 46 | 1.0 | 3 years |
| B | 1 | Corn | - | 62 | - | - | - |
| B | 2 | Wheat | Cover Cropping | 63 | - | - | - |
| B | 3 | Soybean | Cover Cropping | 65 | - | - | - |
| B | 4 | Corn | Cover Cropping, Agroforestry | 68 | - | - | - |
| B | 5 | Wheat | Cover Cropping, Agroforestry | 64 | - | - | - |
| B | 6 | Soybean | Cover Cropping, Agroforestry | 61 | - | - | - |
| B | 7 | Corn | **Forecasted** : Agroforestry | - | 60 | 0.8 | 5 Years |
| C | 1 | Wheat | - | 45 | - | - | - |
| C | 2 | Corn | No-Till Farming | 43 | - | - | - |
| C | 3 | Soybean | No-Till Farming | 40 | - | - | - |
| C | 4 | Wheat | No-Till Farming, Crop Rotation | 42 | - | - | - |

(continued)

| Far m | Yea r | Crop | Agricultural practices | GHG emission s | Forecaste d GHG emissions | Dynami c adoptio n index | Estimate d Transitio n time |
|---|---|---|---|---|---|---|---|
| C | 5 | Corn | No-Till Farming, Crop Rotation | 38 | - | - | - |
| C | 6 | Soybea n | No-Till Farming, Crop Rotation | 37 | - | - | - |
| C | 7 | Wheat | **Forecasted** : Cover Cropping | - | 36 | 0.7 | 4 years |
| D | 1 | Corn | - | 55 | - | - | - |
| D | 2 | Wheat | Reduced Tillage | 57 | - | - | - |
| D | 3 | Soybea n | Reduced Tillage | 58 | - | - | - |
| D | 4 | Corn | Reduced Tillage, Cover Cropping | 60 | - | - | - |
| D | 5 | Wheat | Reduced Tillage, Cover Cropping | 59 | - | - | - |
| D | 6 | Soybea n | Reduced Tillage, Cover Cropping | 56 | - | - | - |
| D | 7 | Corn | **Forecasted** : Reduced Tillage | - | 54 | 0.6 | 6 years |

The written description describes the subject matter herein to enable any person skilled in the art to make and use the embodiments. The scope of the subject matter embodiments is defined herein and may include other modifications that occur to those skilled in the art. Such other modifications are intended to be within the scope of the present disclosure if they have similar elements that do not differ from the literal language of the embodiments or if they include equivalent elements with insubstantial differences from the literal language of the embodiments described herein.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated herein by the following claims.

## Claims

1. A processor implemented method (200), comprising:

   receiving (202), via one or more processors, a plurality of data pertaining to an agriculture land for a specific season from a plurality of seasons, wherein the plurality of data comprises a plurality of aerial and non-aerial data, and a plurality of followed agriculture practices;

   estimating (204), via the one or more processors, a plurality of greenhouse gases (GHG) emissions associated with each of a plurality of agricultural activity within each of the plurality of seasons using a machine learning model trained with the plurality of data;

   creating (206), via the one or more processors, a knowledge graph capturing a causal relationship between the plurality of data and the plurality of GHG emissions; **characterised by** the following steps:

   transforming (208), via the one or more processors, the knowledge graph into a plurality of feature embeddings using a graph embedding technique, wherein the plurality of feature embeddings capture (i) a domain-specific context, (ii) a semantic context and (iii) inter-relationships between the plurality of data and the plurality of GHG emissions;

   training (210), via the one or more processors, a graph based machine learning model with graph-based regularization and attention mechanisms using the plurality of feature embeddings and the plurality of GHG emissions;

   predicting (212), via the one or more processors, a future value of the plurality of GHG emissions using the graph based machine learning model for a subsequent season of the specific season from the plurality of seasons;

   recommending (214), via the one or more processors, a plurality of sustainable agriculture practices to one or more users based on the future value of the plurality of GHG emissions and the plurality of feature embeddings of the knowledge graph;

   computing (216), via the one or more processors, a dynamic adoption index using the future value of the plurality of GHG emissions, a plurality of temporal weights derived from the knowledge graph, the recommended plurality of sustainable agriculture practices, and the plurality of followed agriculture practices; and

   estimating (218), via the one or more processors, a time required by each user from the one or more users using a machine learning model for transitioning to regenerative agriculture practices based on the dynamic adoption index, and one or more factors.

2. The processor implemented method as claimed in claim 1, wherein recommending the plurality of sustainable agriculture practices enables minimizing the plurality of GHG emissions to an optimal level.

3. The processor implemented method as claimed in claim 1, wherein the one or more factors include user expertise, availability of resources, financial constraints, and regional conditions.

4. The processor implemented method as claimed in claim 1, wherein the time required by each user from the one or more users for transitioning to regenerative agriculture practices is dynamically updated with each season from the plurality of seasons.

5. A system (100), comprising:

   a memory (102) storing instructions;
   one or more communication interfaces (106); and
   one or more hardware processors (104) coupled to the memory (102) via the one or more communication interfaces (106), wherein the one or more hardware processors (104) are configured by the instructions to:

   receive a plurality of data pertaining to an agriculture land for a specific season from a plurality of seasons, wherein the plurality of data comprises a plurality of aerial and non-aerial data, and a plurality of followed agriculture practices;

estimate a plurality of greenhouse gases (GHG) emissions associated with each of a plurality of agricultural activity within each of the plurality of seasons using a machine learning model trained with the plurality of data; **characterised in that** the system will further:

create a knowledge graph capturing a causal relationship between the plurality of data and the plurality of GHG emissions;

transform the knowledge graph into a plurality of feature embeddings using a graph embedding technique, wherein the plurality of feature embeddings capture (i) a domain-specific context, (ii) a semantic context and (iii) inter-relationships between the plurality of data and the plurality of GHG emissions;

train a graph based machine learning model with graph-based regularization and attention mechanisms using the plurality of feature embeddings and the plurality of GHG emissions;

predict a future value of the plurality of GHG emissions using the graph based machine learning model for a subsequent season of the specific season from the plurality of seasons;

recommend a plurality of sustainable agriculture practices to one or more users based on the future value of the plurality of GHG emissions and the plurality of feature embeddings of the knowledge graph;

compute a dynamic adoption index using the future value of the plurality of GHG emissions, a plurality of temporal weights derived from the knowledge graph, the recommended plurality of sustainable agriculture practices, and the plurality of followed agriculture practices; and

estimate a time required by each user from the one or more users using a machine learning model for transitioning to regenerative agriculture practices based on the dynamic adoption index, and one or more factors.

6. The system as claimed in claim 5, wherein recommending the plurality of sustainable agriculture practices enables minimizing the plurality of GHG emissions to an optimal level.

7. The system as claimed in claim 5, wherein the one or more factors include user expertise, availability of resources, financial constraints, and regional conditions.

8. The system as claimed in claim 5, wherein the time required by each user from the one or more users for transitioning to regenerative agriculture practices is dynamically updated with each season from the plurality of seasons.

9. One or more non-transitory machine-readable information storage mediums comprising one or more instructions which when executed by one or more hardware processors cause:

receiving a plurality of data pertaining to an agriculture land for a specific season from a plurality of seasons, wherein the plurality of data comprises a plurality of aerial and non-aerial data, and a plurality of followed agriculture practices;

estimating a plurality of greenhouse gases (GHG) emissions associated with each of a plurality of agricultural activity within each of the plurality of seasons using a machine learning model trained with the plurality of data;

creating a knowledge graph capturing a causal relationship between the plurality of data and the plurality of GHG emissions;

transforming the knowledge graph into a plurality of feature embeddings using a graph embedding technique, wherein the plurality of feature embeddings capture (i) a domain-specific context, (ii) a semantic context and (iii) inter-relationships between the plurality of data and the plurality of GHG emissions;

training a graph based machine learning model with graph-based regularization and attention mechanisms using the plurality of feature embeddings and the plurality of GHG emissions;

predicting a future value of the plurality of GHG emissions using the graph based machine learning model for a subsequent season of the specific season from the plurality of seasons;

recommending a plurality of sustainable agriculture practices to one or more users based on the future value of the plurality of GHG emissions and the plurality of feature embeddings of the knowledge graph;

computing a dynamic adoption index using the future value of the plurality of GHG emissions, a plurality of temporal weights derived from the knowledge graph, the recommended plurality of sustainable agriculture practices, and the plurality of followed agriculture practices; and

estimating a time required by each user from the one or more users using a machine learning model for transitioning to regenerative agriculture practices based on the dynamic adoption index, and one or more factors.

EP 4 564 248 B1

10. The one or more non-transitory machine-readable information storage mediums as claimed in claim 9, wherein recommending the plurality of sustainable agriculture practices enables minimizing the plurality of GHG emissions to an optimal level.

11. The one or more non-transitory machine-readable information storage mediums as claimed in claim 9, wherein the one or more factors include user expertise, availability of resources, financial constraints, and regional conditions.

12. The one or more non-transitory machine-readable information storage mediums as claimed in claim 9, wherein the time required by each user from the one or more users for transitioning to regenerative agriculture practices is dynamically updated with each season from the plurality of seasons.

**Patentansprüche**

1. Prozessorimplementiertes Verfahren (200), umfassend:

Empfangen (202), über einen oder mehrere Prozessoren, einer Mehrzahl von Daten, die sich auf ein landwirtschaftliches Land für eine bestimmte Jahreszeit aus einer Mehrzahl von Jahreszeiten beziehen, wobei die Mehrzahl von Daten eine Mehrzahl von Luft- und Nicht-Luft-Daten und eine Mehrzahl von befolgten landwirtschaftlichen Praktiken umfasst;
Schätzen (204), über den einen oder die mehreren Prozessoren, einer Mehrzahl von Treibhausgas-(Green-House Gas, GHG)-Emissionen, die mit jeder einer Mehrzahl von landwirtschaftlichen Aktivitäten innerhalb jeder der Mehrzahl von Jahreszeiten assoziiert sind, unter Verwendung eines maschinellen Lernmodells, das mit der Mehrzahl von Daten trainiert ist;
Erzeugen (206), über den einen oder die mehreren Prozessoren, eines Wissensgraphen, der eine kausale Beziehung zwischen der Mehrzahl von Daten und der Mehrzahl von GHG-Emissionen erfasst;
Transformieren (208), über den einen oder die mehreren Prozessoren, des Wissensgraphen in eine Mehrzahl von Merkmalseinbettungen unter Verwendung einer Grapheneinbettungstechnik, wobei die Mehrzahl von Merkmalseinbettungen (i) einen domänenspezifischen Kontext, (ii) einen semantischen Kontext und (iii) Wechselbeziehungen zwischen der Mehrzahl von Daten und der Mehrzahl von GHG-Emissionen erfasst;
Trainieren (210), über den einen oder die mehreren Prozessoren, eines graphenbasierten maschinellen Lernmodells mit graphenbasierten Regularisierungs- und Aufmerksamkeitsmechanismen unter Verwendung der Mehrzahl von Merkmalseinbettungen und der Mehrzahl von GHG-Emissionen;
Vorhersagen (212), über den einen oder die mehreren Prozessoren, eines zukünftigen Werts der Mehrzahl von GHG-Emissionen unter Verwendung des graphenbasierten maschinellen Lernmodells für eine nachfolgende Jahreszeit der bestimmten Jahreszeit aus der Mehrzahl von Jahreszeiten;
Empfehlen (214), über den einen oder die mehreren Prozessoren, einer Mehrzahl von nachhaltigen landwirtschaftlichen Praktiken für einen oder mehrere Benutzer basierend auf dem zukünftigen Wert der Mehrzahl von GHG-Emissionen und der Mehrzahl von Merkmalseinbettungen des Wissensgraphen;
Berechnen (216), über den einen oder die mehreren Prozessoren, eines dynamischen Adoptionsindex unter Verwendung des zukünftigen Werts der Mehrzahl von GHG-Emissionen, einer Mehrzahl von zeitlichen Gewichtungen, die aus dem Wissensgraphen abgeleitet sind, der empfohlenen Mehrzahl von nachhaltigen landwirtschaftlichen Praktiken und der Mehrzahl von verfolgten landwirtschaftlichen Praktiken; und
Schätzen (218), über den einen oder die mehreren Prozessoren, einer Zeit, die von jedem Benutzer von dem einen oder den mehreren Benutzern benötigt wird, unter Verwendung eines maschinellen Lernmodells zum Übergang zu regenerativen landwirtschaftlichen Praktiken basierend auf dem dynamischen Adoptionsindex und einem oder mehreren Faktoren.

2. Prozessorimplementiertes Verfahren nach Anspruch 1, wobei das Empfehlen der Mehrzahl von nachhaltigen landwirtschaftlichen Praktiken das Minimieren der Mehrzahl von GHG-Emissionen auf ein optimales Niveau ermöglicht.

3. Prozessorimplementiertes Verfahren nach Anspruch 1, wobei der eine oder die mehreren Faktoren Benutzerexpertise, Verfügbarkeit von Ressourcen, finanzielle Einschränkungen und regionale Bedingungen beinhalten.

4. Prozessorimplementiertes Verfahren nach Anspruch 1, wobei die Zeit, die von jedem Benutzer von dem einen oder den mehreren Benutzern zum Übergang zu regenerativen landwirtschaftlichen Praktiken benötigt wird, mit jeder Jahreszeit aus der Mehrzahl von Jahreszeiten dynamisch aktualisiert wird.

12

5. System (100), umfassend:

> einen Speicher (102), der Anweisungen speichert;
> eine oder mehrere Kommunikationsschnittstellen (106); und
> einen oder mehrere Hardwareprozessoren (104), die über die eine oder die mehreren Kommunikationsschnittstellen (106) mit dem Speicher (102) gekoppelt sind, wobei der eine oder die mehreren Hardwareprozessoren (104) durch die Anweisungen konfiguriert sind zum:

>> Empfangen einer Mehrzahl von Daten, die sich auf ein landwirtschaftliches Land für eine bestimmte Jahreszeit aus einer Mehrzahl von Jahreszeiten beziehen, wobei die Mehrzahl von Daten eine Mehrzahl von Luft- und Nicht-Luft-Daten und eine Mehrzahl von befolgten landwirtschaftlichen Praktiken umfasst;
>> Schätzen einer Mehrzahl von Treibhausgas-(Green-House Gas, GHG)-Emissionen, die mit jeder einer Mehrzahl von landwirtschaftlichen Aktivitäten innerhalb jeder der Mehrzahl von Jahreszeiten assoziiert sind, unter Verwendung eines maschinellen Lernmodells, das mit der Mehrzahl von Daten trainiert ist; **dadurch gekennzeichnet, dass** das System ferner bewirkt:

>>> Erzeugen eines Wissensgraphen, der eine kausale Beziehung zwischen der Mehrzahl von Daten und der Mehrzahl von GHG-Emissionen erfasst;
>>> Transformieren des Wissensgraphen in eine Mehrzahl von Merkmalseinbettungen unter Verwendung einer Grapheneinbettungstechnik, wobei die Mehrzahl von Merkmalseinbettungen (i) einen domänenspezifischen Kontext, (ii) einen semantischen Kontext und (iii) Wechselbeziehungen zwischen der Mehrzahl von Daten und der Mehrzahl von GHG-Emissionen erfasst;
>>> Trainieren eines graphenbasierten maschinellen Lernmodells mit graphenbasierten Regularisierungs- und Aufmerksamkeitsmechanismen unter Verwendung der Mehrzahl von Merkmalseinbettungen und der Mehrzahl von GHG-Emissionen;
>>> Vorhersagen eines zukünftigen Werts der Mehrzahl von GHG-Emissionen unter Verwendung des graphenbasierten maschinellen Lernmodells für eine nachfolgende Jahreszeit der bestimmten Jahreszeit aus der Mehrzahl von Jahreszeiten;
>>> Empfehlen einer Mehrzahl von nachhaltigen landwirtschaftlichen Praktiken für einen oder mehrere Benutzer basierend auf dem zukünftigen Wert der Mehrzahl von GHG-Emissionen und der Mehrzahl von Merkmalseinbettungen des Wissensgraphen;
>>> Berechnen eines dynamischen Adoptionsindex unter Verwendung des zukünftigen Werts der Mehrzahl von GHG-Emissionen, einer Mehrzahl von zeitlichen Gewichtungen, die aus dem Wissensgraphen abgeleitet sind, der empfohlenen Mehrzahl von nachhaltigen landwirtschaftlichen Praktiken und der Mehrzahl von verfolgten landwirtschaftlichen Praktiken; und
>>> Schätzen einer Zeit, die von jedem Benutzer von dem einen oder den mehreren Benutzern benötigt wird, unter Verwendung eines maschinellen Lernmodells zum Übergang zu regenerativen landwirtschaftlichen Praktiken basierend auf dem dynamischen Adoptionsindex und einem oder mehreren Faktoren.

6. System nach Anspruch 5, wobei das Empfehlen der Mehrzahl von nachhaltigen landwirtschaftlichen Praktiken das Minimieren der Mehrzahl von GHG-Emissionen auf ein optimales Niveau ermöglicht.

7. System nach Anspruch 5, wobei der eine oder die mehreren Faktoren Benutzerexpertise, Verfügbarkeit von Ressourcen, finanzielle Einschränkungen und regionale Bedingungen beinhalten.

8. System nach Anspruch 5, wobei die Zeit, die von jedem Benutzer von dem einen oder den mehreren Benutzern zum Übergang zu regenerativen landwirtschaftlichen Praktiken benötigt wird, mit jeder Jahreszeit aus der Mehrzahl von Jahreszeiten dynamisch aktualisiert wird.

9. Ein oder mehrere nichtflüchtige maschinenlesbare Informationsspeichermedien, die eine oder mehrere Anweisungen umfassen, die bei Ausführung durch einen oder mehrere Hardwareprozessoren bewirken:

> Empfangen einer Mehrzahl von Daten, die sich auf ein landwirtschaftliches Land für eine bestimmte Jahreszeit aus einer Mehrzahl von Jahreszeiten beziehen, wobei die Mehrzahl von Daten eine Mehrzahl von Luft- und Nicht-Luft-Daten und eine Mehrzahl von befolgten landwirtschaftlichen Praktiken umfasst;
> Schätzen einer Mehrzahl von Treibhausgas-(Green-House Gas, GHG)-Emissionen, die mit jeder einer Mehrzahl von landwirtschaftlichen Aktivitäten innerhalb jeder der Mehrzahl von Jahreszeiten assoziiert sind, unter Verwendung eines maschinellen Lernmodells, das mit der Mehrzahl von Daten trainiert ist;

Erzeugen eines Wissensgraphen, der eine kausale Beziehung zwischen der Mehrzahl von Daten und der Mehrzahl von GHG-Emissionen erfasst;

Transformieren des Wissensgraphen in eine Mehrzahl von Merkmalseinbettungen unter Verwendung einer Grapheneinbettungstechnik, wobei die Mehrzahl von Merkmalseinbettungen (i) einen domänenspezifischen Kontext, (ii) einen semantischen Kontext und (iii) Wechselbeziehungen zwischen der Mehrzahl von Daten und der Mehrzahl von GHG-Emissionen erfasst;

Trainieren eines graphenbasierten maschinellen Lernmodells mit graphenbasierten Regularisierungs- und Aufmerksamkeitsmechanismen unter Verwendung der Mehrzahl von Merkmalseinbettungen und der Mehrzahl von GHG-Emissionen;

Vorhersagen eines zukünftigen Werts der Mehrzahl von GHG-Emissionen unter Verwendung des graphenbasierten maschinellen Lernmodells für eine nachfolgende Jahreszeit der bestimmten Jahreszeit aus der Mehrzahl von Jahreszeiten;

Empfehlen einer Mehrzahl von nachhaltigen landwirtschaftlichen Praktiken für einen oder mehrere Benutzer basierend auf dem zukünftigen Wert der Mehrzahl von GHG-Emissionen und der Mehrzahl von Merkmalseinbettungen des Wissensgraphen;

Berechnen eines dynamischen Adoptionsindex unter Verwendung des zukünftigen Werts der Mehrzahl von GHG-Emissionen, einer Mehrzahl von zeitlichen Gewichtungen, die aus dem Wissensgraphen abgeleitet sind, der empfohlenen Mehrzahl von nachhaltigen landwirtschaftlichen Praktiken und der Mehrzahl von verfolgten landwirtschaftlichen Praktiken; und

Schätzen einer Zeit, die von jedem Benutzer von dem einen oder den mehreren Benutzern benötigt wird, unter Verwendung eines maschinellen Lernmodells zum Übergang zu regenerativen landwirtschaftlichen Praktiken basierend auf dem dynamischen Adoptionsindex und einem oder mehreren Faktoren.

**10.** Ein oder mehrere nichtflüchtige maschinenlesbare Informationsspeichermedien nach Anspruch 9, wobei das Empfehlen der Mehrzahl von nachhaltigen landwirtschaftlichen Praktiken das Minimieren der Mehrzahl von GHG-Emissionen auf ein optimales Niveau ermöglicht.

**11.** Ein oder mehrere nichtflüchtige maschinenlesbare Informationsspeichermedien nach Anspruch 9, wobei der eine oder die mehreren Faktoren Benutzerexpertise, Verfügbarkeit von Ressourcen, finanzielle Einschränkungen und regionale Bedingungen beinhalten.

**12.** Ein oder mehrere nichtflüchtige maschinenlesbare Informationsspeichermedien nach Anspruch 9, wobei die Zeit, die von jedem Benutzer von dem einen oder den mehreren Benutzern zum Übergang zu regenerativen landwirtschaftlichen Praktiken benötigt wird, mit jeder Jahreszeit aus der Mehrzahl von Jahreszeiten dynamisch aktualisiert wird.

## Revendications

**1.** Procédé mis en œuvre par processeur (200), comprenant :

la réception (202), via un ou plusieurs processeurs, d'une pluralité de données relatives à une terre agricole pour une saison spécifique parmi une pluralité de saisons, dans lequel la pluralité de données comprend une pluralité de données aériennes et non aériennes, et une pluralité de pratiques agricoles suivies ;

l'estimation (204), via les un ou plusieurs processeurs, d'une pluralité d'émissions de gaz à effet de serre (GES) associées à chacune d'une pluralité d'activités agricoles dans chacune de la pluralité de saisons en utilisant un modèle d'apprentissage machine entraîné avec la pluralité de données ;

la création (206), via les un ou plusieurs processeurs, d'un graphique de connaissances capturant une relation causale entre la pluralité de données et la pluralité d'émissions de GES ;

la transformation (208), via les un ou plusieurs processeurs, du graphique de connaissances en une pluralité d'intégrations de caractéristiques en utilisant une technique d'intégration de graphique, dans lequel la pluralité d'intégrations de caractéristiques capturent (i) un contexte spécifique à un domaine, (ii) un contexte sémantique et (iii) des interrelations entre la pluralité de données et la pluralité d'émissions de GES ; **caractérisé par** les étapes suivantes :

l'entraînement (210), via les un ou plusieurs processeurs, d'un modèle d'apprentissage machine basé sur un graphique avec des mécanismes de régularisation et d'attention basés sur un graphique en utilisant la pluralité d'intégrations de caractéristiques et la pluralité d'émissions de GES ;

la prédiction (212), via les un ou plusieurs processeurs, d'une valeur future de la pluralité d'émissions de GES en utilisant le modèle d'apprentissage machine basé sur un graphique pour une saison ultérieure à la saison spécifique parmi la pluralité de saisons ;

la recommandation (214), via les un ou plusieurs processeurs, d'une pluralité de pratiques agricoles durables à un ou plusieurs utilisateurs sur la base de la valeur future de la pluralité d'émissions de GES et de la pluralité d'intégrations de caractéristiques du graphique de connaissances ;

le calcul (216), via les un ou plusieurs processeurs, d'un indice d'adoption dynamique en utilisant la valeur future de la pluralité d'émissions de GES, une pluralité de poids temporels dérivés du graphique de connaissances, la pluralité recommandée de pratiques agricoles durables, et la pluralité de pratiques agricoles suivies ; et

l'estimation (218), via les un ou plusieurs processeurs, d'un temps requis par chaque utilisateur parmi les un ou plusieurs utilisateurs en utilisant un modèle d'apprentissage machine pour la transition vers des pratiques agricoles régénératives sur la base de l'indice d'adoption dynamique, et d'un ou plusieurs facteurs.

2. Procédé mis en œuvre par processeur selon la revendication 1, dans lequel la recommandation de la pluralité de pratiques agricoles durables permet de minimiser la pluralité d'émissions de GES à un niveau optimal.

3. Procédé mis en œuvre par processeur selon la revendication 1, dans lequel les un ou plusieurs facteurs incluent une expertise d'utilisateur, une disponibilité de ressources, des contraintes financières, et des conditions régionales.

4. Procédé mis en œuvre par processeur selon la revendication 1, dans lequel le temps requis par chaque utilisateur parmi les un ou plusieurs utilisateurs pour la transition vers des pratiques agricoles régénératives est mis à jour dynamiquement avec chaque saison parmi la pluralité de saisons.

5. Système (100), comprenant :

une mémoire (102) stockant des instructions ;

une ou plusieurs interfaces de communication (106) ; et

un ou plusieurs processeurs matériels (104) couplés à la mémoire (102) via les une ou plusieurs interfaces de communication (106), dans lequel les un ou plusieurs processeurs matériels (104) sont configurés par les instructions pour :

recevoir une pluralité de données relatives à une terre agricole pour une saison spécifique parmi une pluralité de saisons, dans lequel la pluralité de données comprend une pluralité de données aériennes et non aériennes, et une pluralité de pratiques agricoles suivies ;

estimer une pluralité d'émissions de gaz à effet de serre (GES) associées à chacune d'une pluralité d'activités agricoles dans chacune de la pluralité de saisons en utilisant un modèle d'apprentissage machine entraîné avec la pluralité de données ; **caractérisé en ce que** le système va en outre :

créer un graphique de connaissances capturant une relation causale entre la pluralité de données et la pluralité d'émissions de GES ;

transformer le graphique de connaissances en une pluralité d'intégrations de caractéristiques en utilisant une technique d'intégration de graphique, dans lequel la pluralité d'intégrations de caractéristiques capturent (i) un contexte spécifique à un domaine, (ii) un contexte sémantique et (iii) des interrelations entre la pluralité de données et la pluralité d'émissions de GES ;

entraîner un modèle d'apprentissage machine basé sur un graphique avec des mécanismes de régularisation et d'attention basés sur un graphique en utilisant la pluralité d'intégrations de caractéristiques et la pluralité d'émissions de GES ;

prédire une valeur future de la pluralité d'émissions de GES en utilisant le modèle d'apprentissage machine basé sur un graphique pour une saison ultérieure à la saison spécifique parmi la pluralité de saisons ;

recommander une pluralité de pratiques agricoles durables à un ou plusieurs utilisateurs sur la base de la valeur future de la pluralité d'émissions de GES et de la pluralité d'intégrations de caractéristiques du graphique de connaissances ;

calculer un indice d'adoption dynamique en utilisant la valeur future de la pluralité d'émissions de GES, une pluralité de poids temporels dérivés du graphique de connaissances, la pluralité recommandée de pratiques agricoles durables, et la pluralité de pratiques agricoles suivies ; et

estimer un temps requis par chaque utilisateur parmi les un ou plusieurs utilisateurs en utilisant un modèle d'apprentissage machine pour la transition vers des pratiques agricoles régénératives sur la base de l'indice d'adoption dynamique, et d'un ou plusieurs facteurs.

6. Système selon la revendication 5, dans lequel la recommandation de la pluralité de pratiques agricoles durables permet de minimiser la pluralité d'émissions de GES à un niveau optimal.

7. Système selon la revendication 5, dans lequel les un ou plusieurs facteurs incluent une expertise d'utilisateur, une disponibilité de ressources, des contraintes financières, et des conditions régionales.

8. Système selon la revendication 5, dans lequel le temps requis par chaque utilisateur parmi les un ou plusieurs utilisateurs pour la transition vers des pratiques agricoles régénératives est mis à jour dynamiquement avec chaque saison parmi la pluralité de saisons.

9. Un ou plusieurs supports de stockage d'informations lisibles par machine non transitoires comprenant une ou plusieurs instructions qui, lorsqu'elles sont exécutées par un ou plusieurs processeurs matériels, amènent :

la réception d'une pluralité de données relatives à une terre agricole pour une saison spécifique parmi une pluralité de saisons, dans lequel la pluralité de données comprend une pluralité de données aériennes et non aériennes, et une pluralité de pratiques agricoles suivies ;
l'estimation d'une pluralité d'émissions de gaz à effet de serre (GES) associées à chacune d'une pluralité d'activités agricoles dans chacune de la pluralité de saisons en utilisant un modèle d'apprentissage machine entraîné avec la pluralité de données ;
la création d'un graphique de connaissances capturant une relation causale entre la pluralité de données et la pluralité d'émissions de GES ;
la transformation du graphique de connaissances en une pluralité d'intégrations de caractéristiques en utilisant une technique d'intégration de graphique, dans lequel la pluralité d'intégrations de caractéristiques capturent (i) un contexte spécifique à un domaine, (ii) un contexte sémantique et (iii) des interrelations entre la pluralité de données et la pluralité d'émissions de GES ;
l'entraînement d'un modèle d'apprentissage machine basé sur un graphique avec des mécanismes de régularisation et d'attention basés sur un graphique en utilisant la pluralité d'intégrations de caractéristiques et la pluralité d'émissions de GES ;
la prédiction d'une valeur future de la pluralité d'émissions de GES en utilisant le modèle d'apprentissage machine basé sur un graphique pour une saison ultérieure à la saison spécifique parmi la pluralité de saisons ;
la recommandation d'une pluralité de pratiques agricoles durables à un ou plusieurs utilisateurs sur la base de la valeur future de la pluralité d'émissions de GES et de la pluralité d'intégrations de caractéristiques du graphique de connaissances ;
le calcul d'un indice d'adoption dynamique en utilisant la valeur future de la pluralité d'émissions de GES, une pluralité de poids temporels dérivés du graphique de connaissances, la pluralité recommandée de pratiques agricoles durables, et la pluralité de pratiques agricoles suivies ; et
l'estimation d'un temps requis par chaque utilisateur parmi les un ou plusieurs utilisateurs en utilisant un modèle d'apprentissage machine pour la transition vers des pratiques agricoles régénératives sur la base de l'indice d'adoption dynamique, et d'un ou plusieurs facteurs.

10. Un ou plusieurs supports de stockage d'informations lisibles par machine non transitoires selon la revendication 9, dans lesquels la recommandation de la pluralité de pratiques agricoles durables permet de minimiser la pluralité d'émissions de GES à un niveau optimal.

11. Un ou plusieurs supports de stockage d'informations lisibles par machine non transitoires selon la revendication 9, dans lesquels les un ou plusieurs facteurs incluent une expertise d'utilisateur, une disponibilité de ressources, des contraintes financières, et des conditions régionales.

12. Un ou plusieurs supports de stockage d'informations lisibles par machine non transitoires selon la revendication 9, dans lesquels le temps requis par chaque utilisateur parmi les un ou plusieurs utilisateurs pour la transition vers des pratiques agricoles régénératives est mis à jour dynamiquement avec chaque saison parmi la pluralité de saisons.

System **100**

Processor(s) **104**

I/O Interface(s) **106**

Memory **102**

Database **108**

Modules **110**

FIG. 1

200

Receiving a plurality of data pertaining to an agriculture land for a specific season from a plurality of seasons, wherein the plurality of data comprises a plurality of aerial and non-aerial data, and a plurality of followed agriculture practices — 202

Estimating a plurality of greenhouse gases (GHG) emissions associated with each of a plurality of agricultural activity within each of the plurality of seasons using a machine learning model trained with the plurality of data — 204

Creating a knowledge graph capturing a causal relationship between the plurality of data and the plurality of GHG emissions

206

Transforming the knowledge graph into a plurality of feature embeddings using a graph embedding technique, wherein the plurality of feature embeddings capture (i) a domain-specific context, (ii) a semantic context and (iii) inter-relationships between the plurality of data and the plurality of GHG emissions — 208

Training a graph-based machine learning model with graph-based regularization and attention mechanisms using the plurality of feature embeddings and the plurality of GHG emissions — 210

A

**FIG. 2A**

A

Predicting a future value of the plurality of GHG emissions using the graph-based machine learning model for a subsequent season of the specific season from the plurality of seasons — 212

Recommending a plurality of sustainable agriculture practices to one or more users based on the future value of the plurality of GHG emissions and the plurality of feature embeddings of the knowledge graph — 214

Computing a dynamic adoption index using the future value of the plurality of GHG emissions, a plurality of temporal weights derived from the knowledge graph, the recommended plurality of sustainable agriculture practices, and the plurality of followed agriculture practices — 216

Estimating a time required by each user from the one or more users using a machine learning model for transitioning to regenerative agriculture practices based on the dynamic adoption index, and one or more factors — 218

**FIG. 2B**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202321080693

- US 2023107533 A1